# DEMANDE DE BREVET EUROPEEN

(11) **EP 0 592 302 A1**
(43) Date de publication de la demande: **13.04.1994**
(21) Numéro de dépôt: 93402444.9
(22) Date de dépôt: 05.10.1993
(51) Int. Cl.: H01H 9/16, H03K 17/691

(54) **Contacts auxiliaires pour appareil électrique**

(30) Priorité: 07.10.1992 FR 9211887
(71) Demandeur: GEC ALSTHOM T ET D SA, F-75016 Paris (FR)
(72) Inventeur: Ebersohl, Gerard, F-69350 La Mulatière (FR)
(74) Mandataire: Fournier, Michel

(57) **Abrégé**

Contacts auxiliaires pour un appareil électrique pouvant prendre un premier et un second état, caractérisés en ce qu'ils sont constitués par les sorties drain source de transistors MOSFET (97) dont les tensions aux bornes prennent l'une ou l'autre de deux valeurs selon que l'appareil est dans le premier ou le second état, les transistors MOSFET étant alimentés par l'intermédiaire des bobines (B1) de tores (T1) bobinés traversés par un conducteur (84) parcouru par un courant nul lorsque l'appareil est dans l'un desdits états et par un courant crénelé lorsque l'appareil est dans l'autre desdits états, ledit courant étant élaboré par un microprocesseur recevant d'un capteur de position une information sur l'état dudit appareil.

## Description

La présente invention concerne les contacts auxiliaires dont sont munis certains appareils électriques, comme par exemple les disjoncteurs, et qui peuvent prendre DEUX positions selon l'état ouvert ou fermé de l'appareil. Un circuit de commande et de contrôle, dans lequel sont insérés ces contacts auxiliaires, permet à l'exploitant, grâce à la connaissance de l'état ouvert ou fermé du disjoncteur, d'exécuter les manoeuvres d'exploitation nécessaires. L'information donnée par ces contacts auxiliaires permet par exemple de commander l'arrêt de l'alimentation des bobines commandant le déclenchement ou l'enclenchement d'un disjoncteur après une manoeuvre de ce dernier, de vérifier les concordances entre pôles d'un même disjoncteur polyphasé, d'alimenter un synoptique, etc..

En général, dans le cas d'un disjoncteur, les contacts auxiliaires comportent un bloc solidaire de la commande du disjoncteur et dans lequel tourne un rotor portant les pièces de contact, ce rotor étant entraîné lors de la manoeuvre de la commande. Un même bloc comporte plusieurs contacts auxiliaires, par exemple jusqu'à 32.

Ces contacts métalliques présentent un défaut, en particulier lorsqu'ils sont installés sur des disjoncteurs à haute tension qui sont manoeuvrés rarement, par exemple une à deux fois par an seulement. On constate en effet que ces contacts peuvent "s'évanouir" en raison de l'augmentation progressive ou brusque de la résistance de contact, due par exemple aux conditions atmosphériques qui oxydent les pièces de contact métalliques, ce qui a pour effet que le courant transmis, généralement de faible intensité, ne passe plus et que le signal observé est erronné.

Cet évanouissement est extrêmement préjudiciable, car il peut induire l'exploitant en erreur et lui faire commettre des manoeuvres dangereuses pour le matériel et le personnel d'exploitation.

Un but de la présente invention est de réaliser des contacts auxiliaires exempts de ce type d'inconvénient. En particulier, on souhaite pouvoir réaliser des contacts auxiliaires non évanouissants quelle que soit l'intensité du courant qui les traverse, cette intensité pouvant par exemple être comprise entre 5 mA et 2A.

Un autre but de l'invention est de réaliser des contacts auxiliaires pouvant être à un potentiel flottant.

Pour résoudre ce problème, le Demandeur s'est tourné vers l'électronique. Dans la demande de brevet français n°91 04 631 déposée le 16 avril 1991, le Demandeur a décrit un capteur de position d'une pièce mobile, pouvant être par exemple la tige de manoeuvre d'un disjoncteur ou un organe lié à la commande du disjoncteur. C'est à partir d'un tel capteur, qui sera précisé dans la suite, que sont réalisés les contacts auxiliaires électroniques de l'invention. Il suffit de savoir maintenant que la position ouverte ou fermée d'un disjoncteur se traduit sous la forme d'un signal binaire qui peut être acheminée par voie optique à un microprocesseur.

L'invention a pour objet des contacts auxiliaires pour un appareil électrique, pouvant prendre un premier et un second état, caractérisés en ce qu'ils sont constitués par les sorties drain source de transistors MOSFET dont les tensions aux bornes prennent l'une ou l'autre de deux valeurs selon que l'appareil est dans le premier ou le second état, les transistors MOSFET étant alimentés par l'intermédiaire des bobines de tores bobinés traversés par un conducteur parcouru par un courant nul lorsque l'appareil est dans l'un desdits états et alimenté par un courant en créneaux lorsque l'appareil est dans l'autre desdits états, ledit courant étant élaboré par un microprocesseur recevant d'un capteur de position une information sur l'état dudit appareil.

L'invention est expliquée en détail maintenant par la description détaillée d'un mode de réalisation, en référence au dessin annexé dans lequel:
- la figure 1 est un schéma par blocs d'un capteur de positiontion utilisé pour la réalisation des contacts auxiliaires de l'invention,
- la figure 2 est un schéma d'un mode de réalisation du circuit électronique utilisé dans le capteur précité,
- la figure 3 est un schéma d'un exemple de réalisation d'un ensemble de contacts auxiliaires selon l'invention,
- la figure 4 est un schéma détaillé du circuit électronique d'un contact auxiliaire de l'ensemble,
- la figure 5 est un diagramme représentant les variations de tension en divers point du circuit électronique précité,
- la figure 6 représente un exemple de réalisation d'un générateur de créneaux,
- la figure 7 est un schéma du circuit du tore d'autosurveillance du dispositif.

L'exemple décrit se rapporte à un disjoncteur, mais il est clair que l'invention s'applique à tout type d'appareil comportant des contacts auxiliaires destinés à fournir une indication sur l'état de cet appareil.

Les contacts auxiliaires de l'invention sont réalisés par un montage qui nécessite la connaissance par un microprocesseur de l'état ouvert ou fermé du disjoncteur.

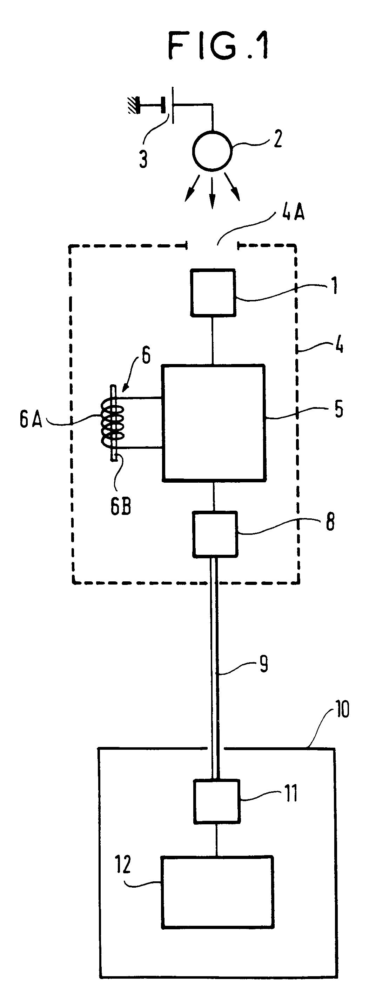

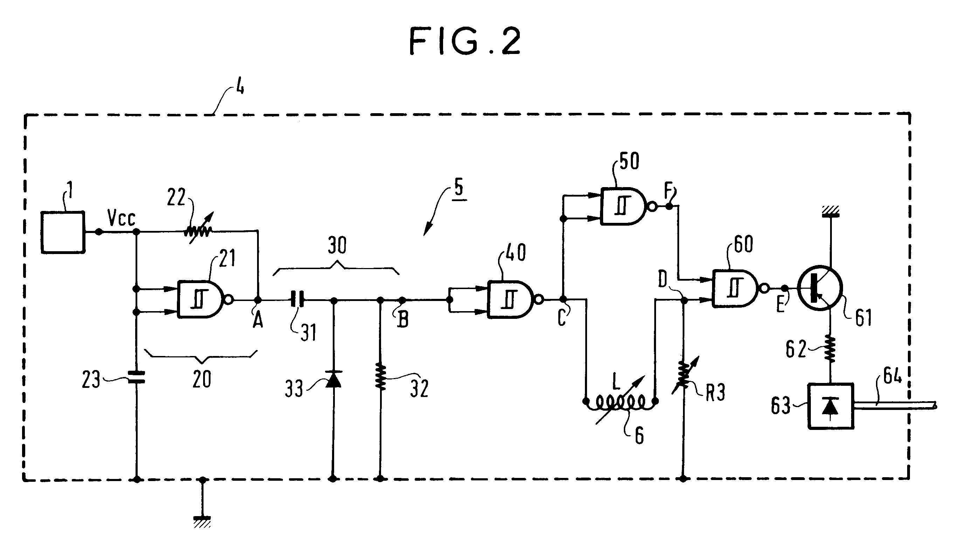

Nous allons, en référence aux figures 1 et 2, rappeler comment il est possible de fournir à un microprocesseur une telle information.

Dans la figure 1, la référence 1 désigne un élément photovoltaïque, alimenté par une source lumineuse 2, par exemple une lampe alimentée par une batterie 3. L'élément photovoltaïque est placé dans une enceinte blindée 4, la lumière traversant une fenêtre 4A; l'élément photovoltaïque fournit une tension Vcc, par exemple de 5 volts, et est capable de délivrer 20 mA en crête; un circuit électronique 5, placé à l'intérieur de l'enceinte blindée et alimenté par l'élément 4, élabore des signaux représentatifs de l'état de l'appareil; à cet effet, le circuit comprend une inductance 6 constituée d'un bobinage 6A et d'un noyau mobile lié à un organe mobile du disjoncteur, par exemple à la commande de ce dernier. Selon l'état du disjoncteur, ouvert ou fermé, le noyau 6B prend deux positions différentes par rapport au bobinage (par exemple à l'intérieur ou à l'extérieur de celui-ci) et par suite, l'inductance 6 prend deux valeurs différentes. Le signal électrique de sortie du circuit 5 est converti en un signal lumineux par un composant optoélectronique 8 et acheminé par une fibre optique 9 jusqu'à une armoire d'appareilllage 10 où un composant optoélectronique 11 assure la conversion du signal lumineux en signal électrique qui est reçu par un microprocesseur 12.

La figure montre la constitution du circuit électronique 5.

Ce circuit comprend un trigger de Schmitt 20 recevant la tension Vcc, et comprenant un composant 21, une résistance ajustable 22 et un condensateur 23; ce trigger délivre en sortie A des impulsions rectangulaires dont les fronts de montée sont distants par exemple de 100 microsecondes et dont la durée est par exemple de 40 microsecondes.

En sortie du trigger est placé un circuit intégrateur 30 qui comprend un condensateur 31, une résitance 32 et une diode 33 permettant d'atténuer fortement les pics dus aux fronts descendants des impulsions.

L'intégrateur est suivi d'un circuit inverseur 40 à seuil s1 qui fournit en sortie C des impulsions de longueur calibrée, par exemple 10 microsecondes.

En C, le signal est envoyé sur un circuit à constante de temps comprenant l'inductance variable 6, de valeur notée L, et une résistance de valeur R3 ajustable.

Le signal de sortie de l'élément inverseur est inversé par un circuit inverseur 50 et le signal de sortie en F est adressé, en même temps que le signal en D, à un circuit inverseur à seuil 60, dont le seuil s2 est supérieur à s1.

En sortie du circuit 60, on obtient des impulsions de courte durée ( 3 microsecondes par exemple) lorsque l'inductance L est faible (noyau sorti) et de plus longue durée (par exemple entre 5 et 10 microsecondes) lorsque lorsque l'inductance est plus élevée (noyau rentré).

Les impulsions en sortie du circuit 60 sont adressées à un transistor 61 alimentant, à travers une résistance 62, une diode émissive 63, par exemple du type TI510 de la société Hewlett Packard, reliée à une fibre optique 64 qui traverse le blindage 4 et achemine les informations, sous forme d'impulsions lumineuses, à l'armoire d'appareillage.

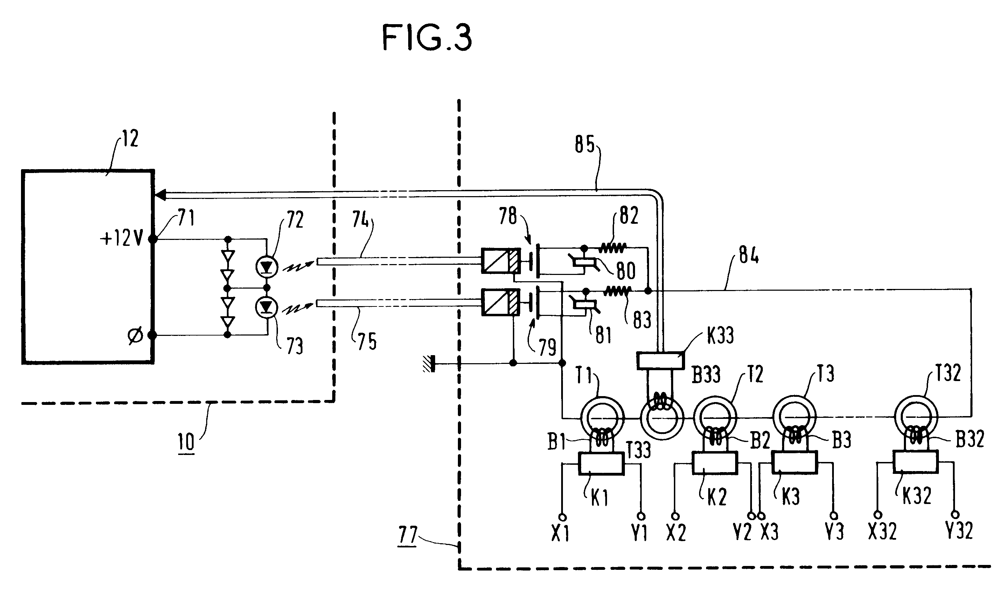

On se reportera à la figure 3.

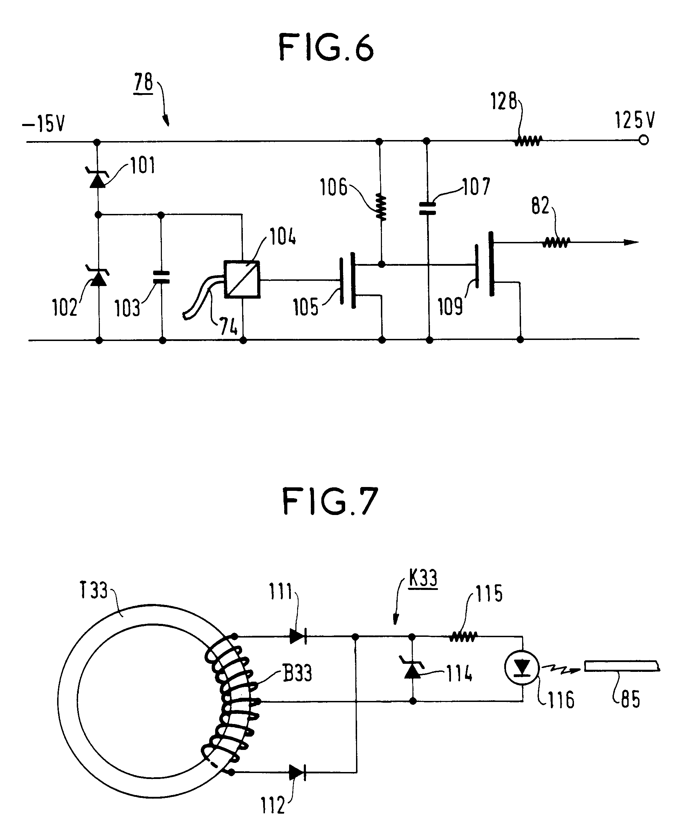

Le microprocesseur 12 est capable d'élaborer, sur une sortie 71, lorsque le tore est dans une position correspondant par exemple à un état fermé du disjoncteur, une tension continue, par exemple de 15 volts, transmise par voie optique, de manière redondante, au moyen de deux photodiodes 72 et 73 et de deux fibres optiques 74 et 75, à des générateurs de créneaux 78 et 79 placés dans une armoire de relayage 77. Un exemple de réalisation des générateurs de créneaux est donné en référence à la figure 6 qui sera expliquée plus loin. Lorsque le microprocesseur détecte l'ouverture du disjoncteur, il cesse son émission d'impulsions.

Les signaux optiques des fibres 74 et 75 sont reçus par deux phototransistors 78 et 79 protégés par des diodes Zener 80 et 81 et alimentant, par l'intermédiaire de résistances 82 et 83, une ligne 84 rebouclée à la masse.

Sur la ligne 84 sont engagés n tores de ferrite en nombre égal à celui du nombre de contacts auxiliaires qu'on souhaite installer, par exemple 32. Ces tores sont caractérisés par le fait que le cycle d'hystérésis permet d'obtenir une induction à saturation plus élevée que l'induction rémanente. Dans ces conditions, le ΔB de l'ordre de 0,3T permet d'obtenir des variations de flux significatives, bien que les ampère-tours d'excitation soient unidirectionnels. Les tores, référencés T1 à T32, comportent chacun un bobinage, respectivement B1 à B32, relié à un circuit électronique K1 à K32 dont les sorties respectives X1Y1, X2Y2, X3Y3, ...,X32Y32 constituent les contacts auxiliaires de l'invention. L'exploitant pourra utiliser ces contacts come il le fait actuellement avec des contacts mécaniques en les reliant à des organes de commande, de contrôle et de visualisation.

La ligne 84 comporte un tore supplémentaire T33 muni d'un bobinage B33 relié à un circuit électronique K33 dont la sortie est reliée par une fibre optique 85 au microprocesseur 12. Ce tore supplémentaire est utilisé, comme on le verra plus loin, pour assurer une autosurveillance lorsque le microprocesseur détecte un changement d'état du disjoncteur. Cette fonction sera expliquée en détail plus loin.

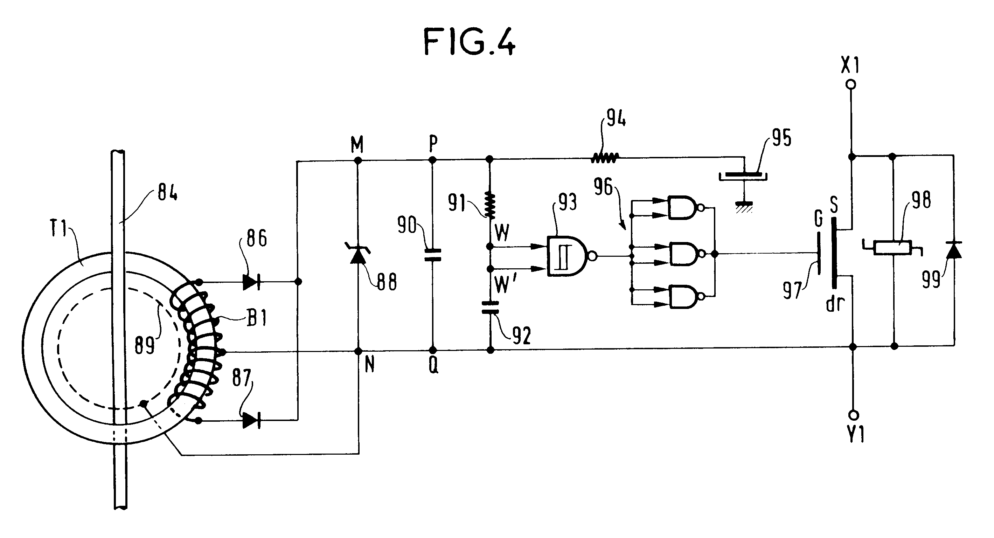

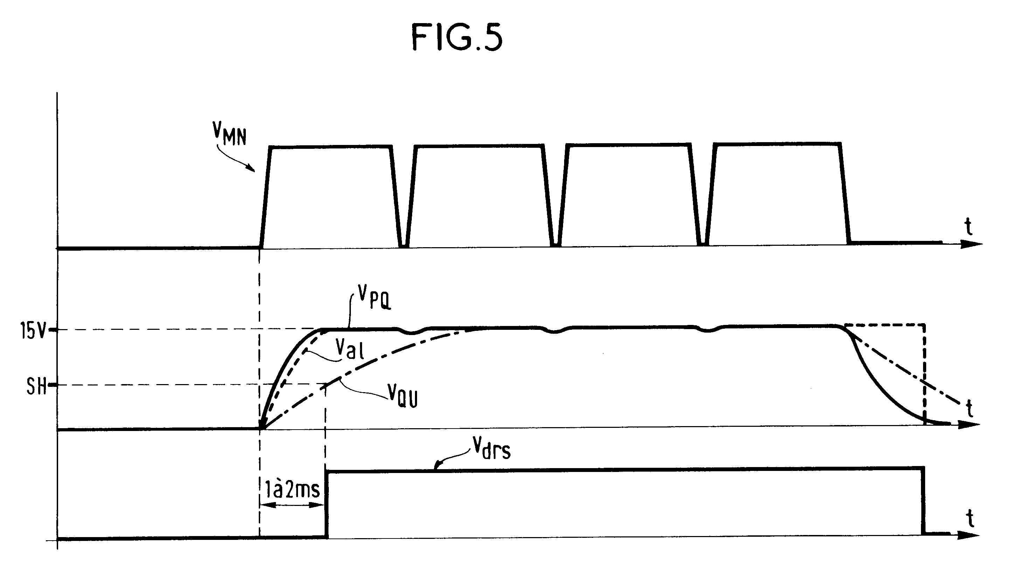

On décrit maintenant, en référence aux figures 4 et 5, l'un des circuits K précités, par exemple le circuit K1 associé au tore T1 et au bobinage B1. Tous les circuits associés aux tores sont identiques à celui qui va être décrit.

Le bobinage B1, dont le point milieu est pris comme potentiel de base, est fournit, lorsque le conducteur 84 est parcouru par un courant en créneaux, une tension de 15 volts redressée par des diodes 86 et 87. Cette tension est limitée par une diode Zener 88 reliée à un écran 89.

On a donc, entre les points M et N, une tension en créneaux serrés comme le montre le diagramme de la figure 5, dont la valeur crête est voisine de 5 volts. Cette tension est lissée par un condensateur 90 disposé entre les points P et Q, et prend une allure rectiligne comme le montre le diagramme de la figure 5. Cette tension est apppliquée à une branche comprenant une résistance 91 et un condensateur 92 attaquant les entrées W et W' d'un trigger de Schmitt inverseur 93, polarisé au moyen d'une tension obtenue par une résistance 94 et un condensateur 95 ayant une constante de temps plus faible que le circuit 91-92 (la courbe d'établissement de la tension est n=référencée Val dans la figure 5). Lorsque la tension aux bornes W'Q du condensateur 93 atteint le seuil de fonctionnement du trigger 93, ce qui se produit 1 à 2 millisecondes après le début du premier créneau, le trigger 93 délivre un échelon de tension, à travers un inverseur 96, est envoyé sur la grille G d'un transistor MOSFET 97 dont les sorties drain (dr) et source (s) constituent les contacts auxiliaires X1 et Y1.

La tension drain source Vdrs est représentée dans la figure 5. Cette tension est présente tant que le disjoncteur est en position fermée, selon l'exemple choisi. Dès que le disjoncteur change d'état, ce qui est détecté par le circuit 5 de la figure 2 et transmis au microprocesseur 12, ce dernier cesse d'alimenter les générateurs d'impulsions et la tension X1Y1 retombe à zéro.

On note que le contact statique est utilisable quel que soit le niveau de courant que l'utilisateur choisira de lui faire traverser; ce peut être par exemple un courant faible de 10mA pour une signalisation bas niveau à 24V, ou un courant de plusieurs ampères sous une tension de 125V.

Ainsi, grâce à l'invention, on peut, à l'aide de trois fibres optiques, déporter, à plusieurs centaines de mètres, 30 ou 40 contacts statiques.

La figure 6 représente un exemple de réalisation d'un générateur de créneaux; on a choisi de représenter le générateur 78, le générateur 79 est identique.

Une tension de 15 volts existant dans le bâtiment de relayage est abaissée à 5 volts au moyen de diodes Zener 101 et 102; elle est filtrée au moyen d'un condensateur 103 et sert à polariser un convertisseur optoélectronique 104 qui reçoit la lumière émise par la fibre optique 74. La tension de sortie du convertisseur 104 est appliquée à la grille d'un transistor HEX-FET 105 relié à un circuit de relaxation comprenant une résistance 106 et un condensateur 107 ; une tension de +125 volts est appliquée au condensateur 107 par l'intermédiaire d'une résistance 108. La borne drain du transistor 105 polarise la grille d'un transistor MOSFET 109 dont la borne drain est reliée à la résistance 82 précédemment décrite.

La figure 7 illustre le montage du tore supplémentaire de surveillance.

La bobine B33 alimente, par l'intermédiaire des diodes 111 et 112, de la diode Zener 114 et de la résistance 115, un convertisseur optoélectronique 116 qui alimente la fibre optique 85. Si le microprocesseur envoie un ordre de fermeture et qu'il ne reçoit pas en retour un signal, qui aurait dû transiter par les fibres 74 et 75, les générateurs 78 et 79, et la ligne 84, il conclut à une panne générale et lance un signal d'alarme.

L'invention s'applique à la réalisation de contacts signaux pout tout type d'appareil électrique pouvant prendre deux états, en particulier pour les appareils électriques de coupure.

## Revendications

1. Contacts auxiliaires pour un appareil électrique pouvant prendre un premier et un second état, caractérisés en ce qu'ils sont constitués par les sorties drain source de transistors MOSFET (97)dont les tensions aux bornes prennent l'une ou l'autre de deux valeurs selon que l'appareil est dans le premier ou le second état, les transistors MOSFET étant alimentés par l'intermédiaire des bobines (B1) de tores (T1) bobinés traversés par un conducteur (84) parcouru par un courant nul lorsque l'appareil est dans l'un desdits états et alimenté par un courant en créneaux lorsque l'appareil est dans l'autre desdits états, ledit courant étant élaboré par un microprocesseur recevant d'un capteur de position une information sur l'état dudit appareil.
